# EUROPÄISCHE PATENTSCHRIFT

(11) **EP 3 047 556 B1**
(45) Veröffentlichungstag und Bekanntmachung des Hinweises auf die Patenterteilung: **08.03.2017**
(21) Anmeldenummer: 14765968.4
(22) Anmeldetag: 15.09.2014
(51) Int. Cl.: H02J 3/38, H01L 31/02, H02H 7/20

(54) **SCHALTUNGSANORDNUNG FÜR EINEN PHOTOVOLTAIKWECHSELRICHTER ZUR AUSSCHALTENTLASTUNG MIT KURZSCHLUSSSCHALTERN UND VERWENDUNGEN DER SCHALTUNGSANORDNUNG**
CIRCUIT ARRANGEMENT FOR A PHOTOVOLTAIC INVERTER FOR BREAK RELIEF USING SHORT-CIRCUIT SWITCHES, AND USES OF SAID CIRCUIT ARRANGEMENT
CIRCUIT POUR ONDULEUR PHOTOVOLTAÏQUE PERMETTANT L'ÉQUILIBRAGE D'UNE MISE HORS CIRCUIT AU MOYEN D'INTERRUPTEURS DE COURT-CIRCUIT, ET UTILISATIONS DU CIRCUIT

(30) Priorität: 17.09.2013 DE 102013110240
(43) Veröffentlichungstag der Anmeldung: 27.07.2016
(73) Patentinhaber: SMA Solar Technology AG, 34266 Niestetal (DE)
(72) Erfinder: FALK, Andreas, 34131 Kassel (DE); LUKAS, Franz, 83024 Rosenheim (DE)
(74) Vertreter: Lahnor, Peter
(86) Internationale Anmeldenummer: PCT/EP2014/069641
(87) Internationale Veröffentlichungsnummer: WO 2015/039998

(56) Entgegenhaltungen:
- EP-A2- 2 337 184
- DE-A1-102011 008 140
- DE-U1-202011 050 696
- US-A1- 2009 167 097

## Beschreibung

Die Erfindung bezieht sich auf eine Schaltungsanordnung für einen Photovoltaikwechselrichter mit den Merkmalen des Oberbegriffs des unabhängigen Patentanspruchs 1. Weiterhin bezieht sich die Erfindung auf die Verwendung einer solchen Schaltungsanordnung.

Wenn mehrere DC/AC-Wandler eingangsseitig über jeweils einen Trennschalter an gemeinsame Busleitungen angeschlossen sind, so fließt im Falle eines schweren Fehlers in einem der DC/AC-Wandler, der einen Kurzschluss zwischen seinen Anschlussleitungen zur Folge hat, der von allen an die Busleitungen angeschlossenen Photovoltaikgeneratoren generierte Kurzschlussstrom über den zwischen dem Busleiter und dem fehlerhaften DC/AC-Wandler vorgesehenen Trennschalter: Um den Kurzschlussstrom mit dem Trennschalter gefahrlos unterbrechen zu können, muss das Grenzabschaltvermögen des Trennschalters für diesen Kurzschlussstrom ausgelegt sein, obwohl dieser ein Mehrfaches des im ungestörten Betrieb über den Trennschalter fließenden und mit dem Trennschalter abzuschaltenden Gleichstroms beträgt.

Sicherungen, über die die Photovoltaikgeneratoren an die Busleitungen angeschlossen sein können, sprechen auf den im geschilderten Fall fließenden Kurzschlussstrom in der Regel nicht an, weil dieser Kurzschlussstrom nur wenig größer als der Nennstrom des jeweiligen Photovoltaikgenerators ist.

Aus der DE 10 2010 017 746 A1 ist eine photovoltaische Anlage mit einem an einen Phptovoltaikwechselrichter angeschlossenen Photovoltaikgenerator bekannt. Der Photovoltaikwechselrichter weist eine DC-Trenneinrichtung auf, die über eine Steuereinrichtung ansteuerbar ist. Weiterhin weist der Photovoltaikwechselrichter eine Kurzschließeinrichtung auf, mit der der Photovoltaikgenerator vor der DC-Trenneinrichtung kurzschließbar ist und die ebenfalls über die Steuereinrichtung ansteuerbar ist. Die DC-Trenneinrichtung kann ein Relais aufweisen, das den Photovoltaikgenerator allpolig von einem DC/AC-Wandler des Photovoltaikwechselrichters trennt. Die Kurzschließeinrichtung kann einen Halbleiterschalter aufweisen.

Aus der DE 10 2009 019 831 A1 ist eine Schaltungsanordnung zum elektrischen Koppeln einer Gleichstromquelle, bspw. eines Photovoltaikgenerators, mit einem Gleichstromverbraucher, bspw. eines Wechselrichters, bekannt. Die Schaltungsanordnung umfasst einen ersten und zweiten Stromeingangsknoten zum Aufnehmen eines von der Gleichstromquelle erzeugten Gleichstroms, einen ersten und zweiten Stromausgangsknoten zum Abgeben des erzeugten Gleichstroms an den Gleichstromverbraucher, ein zwischen dem ersten Stromeingangsknoten und dem ersten Stromausgangsknoten und/oder dem zweiten Stromeingangsknoten und dem zweiten Stromausgangsknoten angeschlossenes Trennmittel zum Unterbrechen der elektrischen Verbindung zwischen den jeweiligen Knoten und ein zwischen dem ersten Stromeingangsknoten und dem zweiten Stromeingangsknoten angeschlossenes Hilfsschaltmittel zum Kurzschließen des ersten und zweiten Stromeingangsknotens. Wird dieses Hilfsschaltmittel zum Kurzschließen geschlossen, ist somit die Gleichstromquelle kurzgeschlossen. Hierdurch kann erreicht werden, dass der Strom zum Verbraucher auf null gesenkt wird. Die Gleichstromquelle erzeugt zwar weiterhin Gleichstrom, dieser fließt aufgrund des Kurzschlusses aber nicht mehr oder allenfalls in sehr geringen Mengen zum Verbraucher. Das Trennmittel kann nun öffnen, um die elektrische Verbindung zwischen den jeweiligen Knoten zu unterbrechen. Für das Trennmittel tritt somit nicht das bekannte Problem auf, auch einen insbesondere großen Gleichstrom zu unterbrechen. Vielmehr kann es im stromlosen Zustand schalten. Entsprechend kann ein kostengünstiges Trennmittel verwendet werden, das nicht zum Schalten unter Last geeignet zu sein braucht. Mit der Frage des sicheren Abschaltens des Kurzschlussstroms durch das Hilfsschaltmittel beschäftigt sich die DE 10 2009 019 831 A1 nicht.

Aus der US 2009/0167097 A1 ist eine Schaltungsanordnung bekannt, bei der ein Interface zwischen die Eingänge eines Wechselrichters und die zum Anschluss eines Photovoltaikarrays eingerichteten Eingänge eines Photovoltaiksystems geschaltet ist. In dem Interface ist ein Trennschalter zur Trennung einer der Verbindungen zwischen den Eingängen des Wechselrichters und den Eingängen Photovoltaiksystems vorgesehen. Ferner ist in dem Interface vor dem Trennschalter ein Kurschlussschalter zwischen die Verbindungen der Eingänge des Photovoltaiksystems mit den Eingängen des Wechselrichters geschaltet. Eine in dem Interface vorgesehene Steuerung taktet den Kurzschlussschalter vor dem Schließen des Trennschalters, um die dem Wechselrichter zugeführte Spannung gegenüber der Leerlaufspannung des Photovoltaikarrays zu reduzieren. Vor dem Öffnen des Trennschalters ist es vorgesehen, den Kurzschlussschalter zu schließen.

Aus der WO 2011/023732 A2 sind eine Bypass- und Schutzschaltung für ein Solarmodul und ein Verfahren zum Steuern des Solarmoduls bekannt. Die Bypass- und Schutzschaltung umfasst einen Eingang zum Anschluss des Solarmoduls, einen Ausgang, ein Bypass-Element, das parallel zu dem Ausgang geschaltet ist, ein Trenn-Element, das zwischen den Eingang und den Ausgang geschaltet ist, und ein Schutzelement in Form einer Diode, die parallel zu dem Eingang geschaltet ist. Dabei ist das Trenn-Element konfiguriert, um eine Verbindung zwischen dem Eingang und dem Ausgang abhängig davon zu steuern, ob das der Bypass- und Schutzschaltung zugeordnete Solarmodul ganz oder teilweise abgeschattet ist oder ein- oder ausgeschaltet werden soll. Das Trenn-Element umfasst einen Schalter, und das Bypass-Element umfasst eine Diode mit einem parallel geschalteten Schalter. Von dem Solarmodul aus ist das Bypass-Element hinter dem Trenn-Element angeordnet. Als Schalter können Relais eingesetzt werden. Bevorzugt sind Halbleiterbauelemente. Im Falle einer Abschattung des angeschlossenen Solarmoduls wird der Schalter des Trenn-Elements geöffnet und der Schalter des Bypass-Elements geschlossen.

Aus der WO 2004/082091 A1 ist ein elektronischer Trennschalter zur Verbindung eines Leistungsversorgungsnetzes und eines Ausgangs zum Anschluss einer Last bekannt. Zwischen dem Eingang und dem Ausgang umfasst der Trennschalter eine Reihenschaltung einer Sicherung, eines Halbleiterschalters und eines Relais. Eine Steuerung steuert den Halbleiterschalter so an, dass ein im Wesentlichen spannungslosen Schalten des Relais erfolgt.

Aus der DE 10 2010 007 452 A1 ist eine Schaltentlastung für einen Trennschalter zur Anwendung im Bereich elektrischer Fahrzeuge bekannt, bei der der Trennschalter eine galvanische Trennung zwischen einer Batterie und einem Zwischenkreis vornehmen muss. Die Schaltentlastung weist mindestens einen Halbleiterschalter auf. Für die Trennung der elektrischen Verbindung wird der abzuschaltende Strom über den Halbleiterschalter geleitet. Dann wird der Trennschalter bei reduziertem Spannungsaufbau abgeschaltet.

Aus der EP 2 148 417 A1 ist eine Wechselrichterschaltungsanordnung für einen Photovoltaikgenerator mit mehreren eingangs seriell geschalteten DC/AC-Wandlern bekannt. An diese eingangsseitige Reihenschaltung der DC/AC-Wandler ist ein Photovoltaikgenerator angeschlossen. Für jeden der DC/AC-Wandler ist ein Überbrückungsschalter vorgesehen. Der Überbrückungsschalter liegt in einem Gleichspannungszwischenkreis und überbrückt in geschlossenem Zustand den jeweiligen DC/AC-Wandler. Parallel zu jedem Überbrückungsschalter ist ein Widerstands-Chopper geschaltet. Jeder Widerstands-Chopper besteht aus einem steuerbaren Halbleiterschalter, einem dazu in Reihe geschalteten Widerstand und einer parallel zu dem Widerstand geschalteten Diode, deren Durchlassrichtung derjenigen des Halbleiterschalters entgegengerichtet ist, so dass sie die Funktion einer Freilaufdiode erfüllt. Die Widerstands-Chopper werden bei geöffneten Überbrückungsschaltern getaktet, um Kondensatoren eingangsseitiger Gleichspannungszwischenkreise der DC/AC-Wandler zu entladen.

Aus der EP 2 337 184 A3 ist eine Anordnung einer Vielzahl von Photovoltaikmodulen und einer Vielzahl von Gleichspannungswandlern bekannt, bei der über eine Vielzahl von jeweils in Serie zwischen den Photovoltaikmodulen und den Gleichspannungswandlern angeordnete Schalter und eine Vielzahl von zwischen den Photovoltaikmodulen angeordnete Schalter in Abhängigkeit der von den jeweiligen Photovoltaikmodulen bereitgestellten Energie die Module wahlweise mit ausgewählten Gleichspannungswandlern verbunden werden, wobei in Abhängigkeit der von den jeweiligen Photovoltaikmodulen bereitgestellten Energie optional mehrere Module parallel geschaltet werden.

### AUFGABE DER ERFINDUNG

Der Erfindung liegt die Aufgabe zugrunde, eine Schaltungsanordnung für einen Photovoltaikwechselrichter bereitzustellen, bei der die Trennschalter zwischen jedem DC/AC-Wandler und den Busleitungen ein deutlich kleineres Grenzausschaltvermögen aufweisen können als der maximale Kurzschlussstrom aller angeschlossenen Photovoltaikgeneratoren und bei der dieser maximale Kurzschlussstrom, wenn er über einen einzigen der DC/AC-Wandler fließt, dennoch sicher abgeschaltet werden kann. Weiterhin sollen vorteilhafte Verwendungen der Schaltungsanordnung aufgezeigt werden.

### LÖSUNG

Die Aufgabe der Erfindung wird durch eine Schaltungsanordnung mit den Merkmalen des unabhängigen Patentanspruchs 1 gelöst. Die abhängigen Patentansprüche 2 bis 11 sind auf bevorzugte Ausführungsformen der erfindungsgemäßen Schaltungsanordnung gerichtet. Die Patentansprüche 12 bis 15 betreffen bevorzugte Verwendungen der erfindungsgemäßen Schaltungsanordnung.

### BESCHREIBUNG DER ERFINDUNG

Die Erfindung geht von einer Schaltungsanordnung für einen Photovoltaikwechselrichter aus, die zwei Busleitungen, Eingangsanschlüsse für mindestens einen Photovoltaikgenerator an die Busleitungen, mindestens einen an die Busleitungen angeschlossenen DC/AC-Wandler, jeweils einen Trennschalter zwischen jedem DC/AC-Wandler und den Busleitungen und mindestens einen Kurzschlusspfad zum Kurzschließen einer zwischen den Busleitungen anliegenden Spannung mit einem Kurzschlussschalter aufweist. Besondere Vorteile weist die vorliegende Erfindung auf, wenn mehrere DC/AC-Wandler parallel zueinander an die Busleitungen angeschlossen sind.

Der mindestens eine Kurzschiusspfad verläuft zwischen den Busleitungen vor allen Trennschaltern. Es ist erfindungsgemäß mindestens ein weiterer Kurzschlusspfad zum Kurzschließen der zwischen den Busleitungen anliegenden Spannung vorhanden. In dem mindestens einen Kurzschlusspfad ist der Kurzschlussschalter mit einer Sicherung in Reihe geschaltet.

Mindestens einer der Kurzschlussschalter kann ein zum Schließen triggerbarer Thyristor sein. Ein Thyristor kann einen großen Kurzschlussstrom sicher schalten. Er wird dazu mit einem nur kleinen Gatestrom getriggert, d. h. leitend geschaltet und bleibt leitend, bis ein durch ihn fließender Haltestrom unterschritten wird. Vorzugsweise sind die in allen Kurzschlusspfaden vorhandenen Kurzschlussschalter Thyristoren.

Vorzugsweise ist der Kurzschlussschalter in dem mindestens einen Kurzschlusspfad zwischen den Busleitungen vor allen Trennschaltern weiterhin mit einem strombegrenzenden Bauteil in Reihe geschaltet. Unter einem strombegrenzenden Bauteil ist hier ein Bauteil zu verstehen, das beim Schließen des Kurzschlussschalters den Strom begrenzt, während der Kurzschlussschalter leitend wird. Insbesondere handelt es sich bei dem strombegrenzenden Bauteil um eine Drossel, beispielsweise eine Dämpfungsdrossel, die nur einen unwesentlichen ohmschen Widerstand aufweist. Grundsätzlich kann das strombegrenzende Bauteil aber auch ein ohmscher Widerstand sein. Verzichtet werden kann auf das strombegrenzende Bauteil, wenn die Sicherung und der Kurzschlussschalter in dem mindestens einen Kurzschlusspfad einen hohen Einschaltstrom tolerieren.

Die mit dem Kurzschlussschalter in dem mindestens einen Kurzschlusspfad zwischen den Busleitungen vor allen Trennschaltern in Reihe geschaltete Sicherung wird hier nicht als strombegrenzendes Bauteil betrachtet. Mit Sicherung wird hier vielmehr ein Bauteil bezeichnet, das vor einem Überstrom schützt, indem es diesen abschaltet. Insbesondere handelt es sich bei der Sicherung um eine Schmelzsicherung, die für das selbsttätige Abschalten des Kurzschlussstroms aller angeschlossenen Photovoltaikgeneratoren geeignet ist. Es kann sich auch um eine triggerbare Sicherung handeln, beispielsweise eine solche, die mit einem Sprengsatz ausgerüstet ist, der nach der Zündung den Strom unterbricht.

Wenn bei der erfindungsgemäßen Schaltungsanordnung ein Strom durch einen der Trennschalter auftritt, der über dessen Grenzausschaltvermögen hinausgeht, können die Kurzschlussschalter in den Kurzschlusspfaden geschlossen werden, so dass diese leitend werden und die zwischen den Busleitungen anliegende Spannung kurzschließen. Dabei kann der Kurzschlussschalter in dem mindestens einen Kurzschlusspfad, der zwischen den Busleitungen vor allen Trennschaltern verläuft und in dem die Sicherung mit dem Kurzschlussschalter in Reihe geschaltet ist, als letztes geschlossen werden, damit die Sicherung nicht sofort dem vollen Kurzschlussstrom ausgesetzt wird. Vielmehr fließt über den mindestens einen Kurzschlusspfad der erfindungsgemäßen Schaltungsanordnung, der zwischen den Busleitungen vor allen Trennschaltern verläuft, zunächst vorzugsweise nur ein Teil des Kurzschlussstroms. Sobald alle Kurzschlussschalter geschlossen sind und die Spannung zwischen den Busleitungen in der Folge auf null zurückgegangen ist, können die Trennschalter gefahrlos geöffnet werden, weil auch über den Schaltkontakten des Trennschalters, über den zunächst der Kurzschlussstrom floss, auch beim Öffnen keine Spannung mehr abfällt. Danach konzentriert sich der Kurzschlussstrom auf den mindestens einen Kurzschlusspfad, der zwischen den Busleitungen vor den Trennschaltern verläuft. Dies führt dazu, dass die in diesem Kurzschlusspfad angeordnete Sicherung auslöst und den Kurzschlussstrom abschaltet, damit der Kurzschlussstrom nicht unnötig lange fließt. Ein vorzeitiges Auslösen der Sicherung tritt bereits wegen des zuvor auch über andere Wege fließenden Kurzschlussstroms nicht auf. Zudem weist eine Schmelzsicherung beim Auslösen eine typische zeitliche Verzögerung auf, die hier genutzt werden kann, um die Trennschalter zu öffnen, bevor der Strom durch den mindestens einen der Kurzschlusspfade abgeschaltet wird, der die Sicherung aufweist und zwischen den Busleitungen vor den Trennschaltern verläuft.

Erfindungsgemäß verläuft der mindestens eine weitere Kurzschlusspfad der erfindungsgemäßen Schaltungsanordnung, sowie bevorzugt jeweils auch alle anderen weiteren Kurzschlusspfade, hinter einem der Trennschalter und zwischen den Anschlussleitungen des zugehörigen DC/AC-Wandlers. Hierdurch werden diese weiteren Kurzschlusspfade trotz geschlossener Kurzschlussschalter durch das Öffnen der Trennschalter deaktiviert, und der gesamte Kurzschlussstrom fließt bei geöffneten Trennschaltern über den mindestens einen Kurzschlusspfad vor den Trennschaltern, in dem die Sicherung vorgesehen ist, so dass diese Sicherung nach dem Öffnen der Trennschalter auslöst.

Vorzugsweise verläuft hinter mindestens zwei der Trennschalter jeweils zwischen den Anschlussleitungen des zugehörigen DC/AC-Wandlers ein weiterer Kurzschlusspfad. Es kann auch hinter jedem der Trennschalter jeweils zwischen den Anschlussleitungen des zugehörigen DC/AC-Wandlers ein weiterer Kurzschlusspfad verlaufen. Vorzugsweise wird aber die Gesamtzahl der Kurzschlusspfade und entsprechend die der Kurzschlussschalter bei der erfindungsgemäßen Schaltungsanordnung auf einem Wert kleiner oder gleich der Gesamtanzahl der parallel geschalteten DC/AC-Wandler gehalten.

In jedem der weiteren Kurzschlusspfade ist vorzugsweise ein strombegrenzendes Bauteil mit dem jeweiligen Kurzschlussschalter in Reihe geschaltet. Dabei ist es vorteilhaft, wenn das strombegrenzende Bauteil in mindestens einem der weiteren Kurzschlusspfade ein Entladewiderstand ist. Beim Schließen des zugehörigen Kurzschlussschalters werden alle eingangsseitigen Zwischenkreiskondensatoren aller DC/AC-Wandler über diesen Entladewiderstand je nach dessen Größe zumindest im Wesentlichen entladen. Dadurch können die Kurzschlussschalter der erfindungsgemäßen Schaltungsanordnung grundsätzlich kleiner ausgelegt werden, weil die in den Zwischenkreiskondensatoren gespeicherte elektrische Energie nicht in den Kurzschlussschaltern, sondern in dem Entladewiderstand in Wärme umgesetzt wird.

Besonders bevorzugt ist es, wenn das strombegrenzende Bauteil in mindestens einem der weiteren Kurzschlusspfade eine Drossel ist. Diese begrenzt zwar den Maximalstrom, dem der damit in Reihe geschaltete Kurzschlussschalter ausgesetzt ist, anders als ein Entladewiderstand ermöglicht sie aber die Reduktion der über den Kurzschlusspfad kurzgeschlossenen Spannung zwischen den Busleitungen bis herab auf null bzw. nahe null, weil ihr ohmscher Widerstand zu vernachlässigen ist.

Bei der erfindungsgemäßen Schaltungsanordnung kann parallel zu dem mindestens einen der Kurzschlusspfade vor den Trennschaltern ein zweiter weiterer Kurzschlusspfad direkt zwischen den Busleitungen verlaufen, wobei der Kurzschlussschalter auch in dem zweiten weiteren Kurzschlusspfad mit einem strombegrenzenden Bauteil und einer Sicherung in Reihe geschaltet ist. Wenn dann die mit den Sicherungen in Reihe geschalteten Kurzschlussschalter als Abschaltthyristoren zum Beispiel in Form sogenannter Gate Turn-Off-Thyristoren (GTOs) ausgeführt sind, können sie nach dem Öffnen der Trennschalter wieder ausgeschaltet werden, noch bevor die mit ihnen in Reihe geschalteten Sicherungen fallen. Mehrere parallel geschaltete Kurzschlusspfade mit Abschaltthyristoren sind dabei sinnvoll, weil keine beliebig großen GTOs verfügbar sind und zudem die Auslegung der Sicherungen in diesem Fall einfacher ist.

Bei einer weiteren konkreten Ausführungsform der erfindungsgemäßen Schaltungsanordnung verlaufen mehrere Kurzschlusspfade zwischen den Busleitungen vor den Trennschaltern, in denen jeweils ein Kurzschlussschalter mit einem strombegrenzenden Bauteil und einer triggerbaren Sicherung in Reihe geschaltet ist. Zum Kurzschließen der Spannung zwischen den Busleitungen wird jeweils einer der Kurzschlussschalter geschlossen. Die mit ihm in Reihe geschaltete Sicherung wird getriggert, sobald die Trennschalter geöffnet und sperrfähig sind. Sperrfähig sind die Trennschalter dann, wenn die Luft bzw. das Schutzgas zwischen den Kontakten des Trennschalters ausreichend deionisiert ist. Dazu muss die Sicherung mit ausreichender Verzögerung triggern. Nach dem Triggern der Sicherung ist der jeweilige Kurzschlusspfad zwar verbraucht, es steht aber mindestens ein weiterer Kurzschlusspfad für eine Wiederholung der geschilderten Abfolge von Schritten zur Verfügung, bevor eine Wartung der Schaltungsanordnung mit Ersatz oder zumindest Rückstellung der getriggerten Sicherungen erfolgen muss.

Vorzugsweise trennen die Trennschalter bei der erfindungsgemäßen Schaltungsanordnung die DC/AC-Wandler allpolig von den Busleitungen. Es kann aber auch eine einpolige Trennung vorgenommen werden. Zudem sind die DC/AC-Wandler ausgangsseitig vorzugsweise über ein gemeinsames AC-Schütz oder einzelne AC-Schütze mit einem Netzanschluss verbindbar. Alle AC-Schütze werden vorzugsweise geöffnet, bevor die Kurzschlussschalter der erfindungsgemäßen Schaltungsanordnung geschlossen werden.

Wesentliches Merkmal der erfindungsgemäßen Verwendung der erfindungsgemäßen Schaltungsanordnung ist, dass die Trennschalter bei leitenden Kurzschlussschaltern geöffnet werden. Nicht jedes Öffnen der Trennschalter verlangt jedoch ein vorheriges Schließen der Kurzschlussschalter. Vielmehr kann dieses Schließen der Kurzschlussschalter für das Öffnen der Trennschalter auf solche Fälle beschränkt werden, in denen ein DC-Strom von den Busleitungen zu mindestens einem der angeschlossenen DC/AC-Wandler fließt, der einen Grenzausschaltstrom mindestens eines der Trennschalter übersteigt. Der von den Busleitungen zu den angeschlossenen DC/AC-Wandler fließende Strom wird bei Photovoltaikwechselrichtern regelmäßig sowieso überwacht.

Beim Schließen der Kurzschlussschalter ist es bevorzugt, wenn der Kurzschlussschalter in dem mindestens einen Kurzschlusspfad, der zwischen den Busleitungen vor allen Trennschaltern verläuft und in dem die Sicherung mit dem Kurzschlussschalter in Reihe geschaltet ist, und jeder mit ihm direkt parallel geschaltete weitere Kurzschlusspfad, der ebenfalls eine mit seinem Kurzschlussschalter in Reihe geschaltete Sicherung aufweist, als letztes geschlossen wird, d. h. erst nachdem alle Kurzschlussschalter in allen anderen Kurzschlusspfaden geschlossen sind, die hinter den Trennschaltern der DC/AC-Wandler verlaufen. Weiterhin ist es bevorzugt, wenn jeder in einem Kurzschlusspfad in Reihe mit einem Entladewiderstand geschaltete Kurzschlussschalter als erstes geschlossen wird, d.h. bevor alle anderen Kurzschlussschalter geschlossen werden.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere der dargestellten relativen Anordnung und den Wirkverbindungen mehrerer Bauteile - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Soweit das Adverb "mindestens" hier dennoch verwendet wird, weist es darauf hin, dass das Vorhandensein mehrerer Elemente nicht unwahrscheinlich ist. Diese Elemente können durch andere Merkmale ergänzt werden oder die einzigen Merkmale sein, die das jeweilige Erzeugnis aufweist.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: zeigt schematisch eine erste Ausführungsform einer erfindungsgemäßen Schaltungsanordnung für einen Photovoltaikwechselrichter mit drei unterschiedlich ausgestalteten, jeweils einen Kurzschlussschalter aufweisenden Kurzschlusspfaden.
- **Fig. 2**: zeigt eine zweite Ausführungsform einer erfindungsgemäßen Schaltungsanordnung, ebenfalls mit drei jeweils einen Kurzschlussschalter aufweisenden Kurzschlusspfaden, wobei hier zwei der Kurzschlusspfade mit gleichem Aufbau direkt zwischen Busleitungen parallel geschaltet sind.
- **Fig. 3**: zeigt eine weitere Ausführungsform einer erfindungsgemäßen Schaltungsanordnung mit vier Kurzschlusspfaden, von denen drei einen gleichen Aufbau aufweisen und jeweils zwischen den Anschlussleitungen eines von drei DC/AC-Wandlern des Photovoltaikwechselrichters und hinter einem Trennschalter dieses DC/AC-Wandlers angeordnet sind; und
- **Fig. 4**: zeigt noch eine weitere Ausführungsform einer erfindungsgemäßen Schaltungsanordnung mit drei direkt zwischen Busleitungen parallel geschalteten, jeweils neben einem Kurzschlussschalter eine triggerbare Sicherung aufweisenden Kurzschlusspfaden.

### FIGURENBESCHREIBUNG

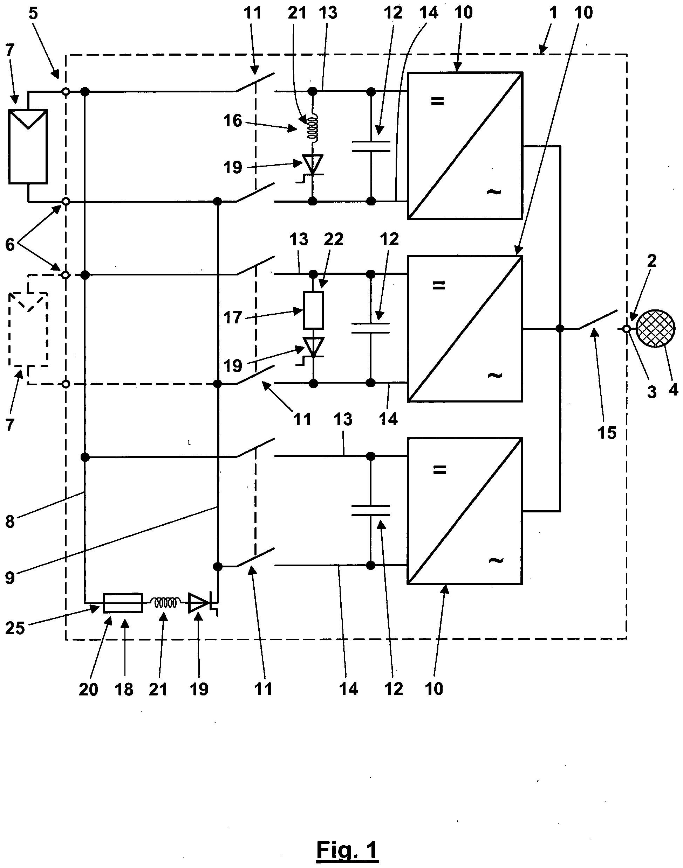

**Fig. 1** illustriert schematisch die für die vorliegende Erfindung wesentlichen Teile einer Schaltungsanordnung für einen Photovoltaikwechselrichter 1. Der Photovoltaikwechselrichter 1 weist noch zusätzliche Bestandteile auf, die hier nicht im Einzelnen dargestellt sind, die der Fachmann aber im Rahmen seines Fachwissens ergänzen wird. Hierzu zählen beispielsweise Sinusfilter am Ausgang 2 des Photovoltaikwechselrichters 1, an dem der Photovoltaikwechselrichter 1 über einen Ausgangsanschluss 3 an ein Wechselstromnetz 4 anschließbar ist.

An seinem Eingang 5 weist der Photovoltaikwechselrichter 1 Eingangsanschlüsse 6 zum Anschließen von Photovoltaikgeneratoren 7 auf. In einer Ausführungsform des Wechselrichters 1 sind Eingangsanschlüsse 6 für einen einzigen Photovoltaikgenerator 7 vorgesehen. Hier sind mit gestrichelten Linien auch noch weitere Eingangsanschlüsse 6 für einen weiteren Photovoltaikgenerator 7 angedeutet. Die Zahl der angeschlossenen Photovoltaikgeneratoren 7 kann auch noch größer als zwei sein. Die Eingangsanschlüsse 6 führen parallel zueinander zu zwei Busleitungen 8 und 9 in dem Photovoltaikwechselrichter 1. An diese Busleitungen 8 und 9 sind mehrere DC/AC-Wandler 10 jeweils über ein Paar von Anschlussleitungen 13 und 14 parallel zueinander angeschlossen. In Fig. 1 und den folgenden Figuren sind drei DC/AC-Wandler 10 dargestellt. Die Anzahl der DC/AC-Wandler 10 kann aber auch nur eins oder zwei betragen oder größer als drei sein. Für jeden der DC/AC-Wandler 10 ist ein allpolig trennender Trennschalter 11 vorgesehen, mit dem er von den Busleitungen 8 und 9 trennbar ist. Weiterhin ist für jeden DC/AC-Wandler 10 ein eingangsseitiger Zwischenkreiskondensator 12 vorgesehen, der von den Busleitungen 8 und 9 aus gesehen hinter dem jeweiligen Trennschalter 11 zwischen die Anschlussleitungen 13 und 14 des DC/AC-Wandlers geschaltet ist.

Wenn in einem der DC/AC-Wandler 10 ein schwerwiegender Fehler auftritt, der seine Anschlussleitungen 13 und 14 kurzschließt, wird der Photovoltaikwechselrichter 1 zunächst durch Öffnen eines ausgangsseitigen AC-Schützes 15 von dem Wechselstromnetz 4 getrennt und die DC/AC-Wandler 10 werden abgeschaltet. Aufgrund des schwerwiegenden Fehlers fließt spätestens dann der gesamte Kurzschlussstrom von allen Photovoltaikgeneratoren 7, die über die Eingangsanschlüsse 6 an die Busleitungen 8 und 9 angeschlossen sind, über den zugehörigen Trennschalter 11 zu dem fehlerbehafteten DC/AC-Wandler und zurück. Grundsätzlich müsste daher das Grenzausschaltvermögen der Trennschalter 11 nicht nur für die im normalen Betrieb auftretenden Ströme ausgelegt sein, sondern auch um diesen deutlich höheren Kurzschlussstrom abschalten zu können. Bei dem Photovoltaikwechselrichter 1 gemäß Fig. 1 sind stattdessen Kurzschlusspfade 16 bis 18 mit darin angeordneten Kurzschlussschaltern 19 in Form triggerbarer Thyristoren vorgesehen, mit deren Hilfe es auch bei deutlich geringerem, beispielsweise in der Größenordnung des Nennstroms liegenden Grenzausschaltvermögen der Trennschalter 11 möglich ist, den Kurzschlussstrom in der geschilderten Fehlersituation sicher abzuschalten.

Einer der Kurzschlusspfade 16 bis 18, konkret der Kurzschlusspfad 18, ist direkt zwischen die Busleitungen 8 und 9 geschaltet, und in ihm sind eine Sicherung 20 in Form einer Schmelzsicherung 25 und eine Drossel 21 mit dem Kurzschlussschalter 19 in Reihe geschaltet. Die beiden anderen Kurzschlusspfade 16 und 17 verlaufen hier jeweils von den Busleitungen 8 und 9 aus gesehen hinter einem Trennschalter 11 zwischen den Anschlussleitungen 13 und 14 des zugehörigen DC/AC-Wandlers 10. Dabei ist in dem Kurzschlusspfad 16 eine Drossel 21 mit dem Kurzschlussschalter 19 in Reihe geschaltet, während in dem Kurzschlusspfad 17 ein Entladewiderstand 22 mit dem dortigen Kurzschlussschalter 19 in Reihe geschaltet ist.

Um den Kurzschlussstrom im Fall eines schwerwiegenden Fehlers in einem der DC/AC-Wandler nach Öffnen des AC-Schützes 15 und Abschalten der DC/AC-Wandler 10 abzuschalten, wird zunächst der Kurzschlussschalter 19 in dem Kurzschlusspfad 17 geschlossen. In der Folge entladen sich die Zwischenkreiskondensatoren 12 aller DC/AC-Wandler 10 über den Entladewiderstand 22. Dabei wird die in den Zwischenkreiskondensatoren 12 gespeicherte Energie in dem Entladewiderstand 22 in Wärme umgesetzt. Anschließend wird zunächst zusätzlich der Kurzschlussschalter 19 in dem Kurzschlusspfad 16 und dann auch der Kurzschlussschalter 19 in dem Kurzschlusspfad 18 geschlossen. Dadurch wird die zwischen den Busleitungen 8 und 9 anliegende Spannung weiter herabgesetzt, als dies über den Entladewiderstand 22 des Kurzschlusspfads 17 hinweg möglich ist. Bei dieser Vorgehensweise wird die Sicherung 20 bislang noch nicht mit dem vollen Kurzschlussstrom der an die Busleitungen 8 und 9 angeschlossen Photovoltaikgeneratoren 7 beaufschlagt, da sich dieser Kurzschlussstrom noch über alle Kurzschlusspfade 16 bis 18, insbesondere aber über die Kurzschlusspfade 16 und 18, d. h. die Kurzschlusspfade ohne Entladewiderstand 22, aufteilt. Beim Schließen der einzelnen Kurzschlussschalter 19 verhindert entweder der Entladewiderstand 22 oder die Drossel 21 das Fließen eines anfangs überhöhten Stroms durch den jeweiligen Kurzschlusspfad 16, 17 oder 18.

Sobald die Spannung zwischen den Busleitungen 8 und 9 mit Hilfe der Kurzschlusspfade 16 bis 18 gegen null reduziert ist, können die Trennschalter 11 auch dann gefahrlos geöffnet werden, wenn ihr Grenzausschaltvermögen nur dem Nennstrom des jeweiligen DC/AC-Wandlers 10 entspricht oder noch kleiner ist. Konkret müssen die Trennschalter 11 keine Lasttrennschalter sein. Sobald dabei alle Trennschalter 11 geöffnet sind, hinter denen ein Kurzschlusspfad 16 oder 17 angeordnet ist oder die zu dem fehlerbehafteten DC/AC-Wandler 10 führen, fließt der gesamte Kurzschlussstrom der an die Busleitungen 8 und 9 angeschlossenen Photovoltaikgeneratoren 7 über den Kurzschlusspfad 18 und damit durch die Schmelzsicherung 25. Die Schmelzsicherung 25 ist so ausgelegt, dass sie bei diesem vollen Kurzschlussstrom fällt und damit den Kurzschlusspfad 18 auftrennt. Damit ist der Kurzschlussstrom endgültig abgeschaltet. Die Schmelzsicherung 25 wird bezüglich ihres Ansprechverhaltens auf den vollen Kurzschlussstrom so ausgelegt, dass sie erst mit einer solchen Zeitverzögerung fällt, dass alle Trennschalter 11 im Bereich ihrer Trennstrecken so weit deionisiert sind, dass sie zwischen ihren Schaltkontakten durch Anliegen der Leerlaufspannung der Photovoltaikgeneratoren 7 nicht wieder leitfähig werden.

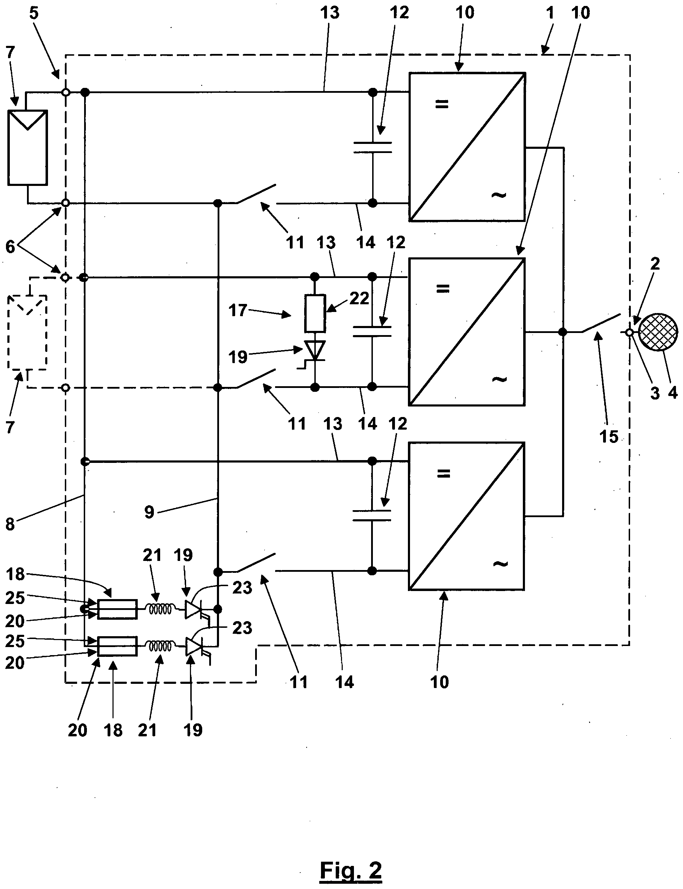

Die erfindungsgemäße Schaltungsanordnung des Photovoltaikwechselrichters 1 gemäß Fig. 2 unterscheidet sich von derjenigen gemäß Fig. 1 in Bezug auf die Kurschlusspfade 17 und 18. So ist hier der Kurzschlusspfad 16 gemäß Fig. 1 weggelassen. Andererseits ist dem Kurzschlusspfad 18 ein identisch aufgebauter weiterer Kurzschlusspfad 18 direkt zwischen den Busleitungen 8 und 9 parallel geschaltet. Die Kurzschlussschalter 19 dieser beiden Kurzschlusspfade 18 sind als Abschaltthyristoren in Form sogenannter GTOs 23 ausgebildet. Damit ist es möglich, den Kurzschlussstrom nach dem Öffnen der Trennschalter 11 auch ohne Fallen der Sicherungen 20 abzuschalten, indem die GTOs 23 ausgeschaltet werden. Die parallel geschalteten Kurzschlusspfade 18 sind hierbei aus den Gründen sinnvoll, dass keine beliebig großen GTOs 23 verfügbar sind und dass die Aufteilung des nach dem Öffnen der Trennschalter 11 fließenden Kurzschlussstroms auf zwei Kurzschlusspfade 18 die Auslegung der Sicherungen 20 vereinfacht. Damit wird es auch leichter möglich, auf den hier eingesparten Kurzschlusspfad 16 gemäß Fig. 1 zu verzichten, mit dem vor dem Schließen der Kurzschlusspfade 18 die Spannung zwischen den Busleitungen 8 und 9 nach dem vorherigen Schließen des Kurzschlusspfads 17 noch weiter herabgesetzt wird und der vor dem Öffnen der Trennschalter 11 einen größeren Anteil des Kurzschlussstroms übernimmt als der Kurzschlusspfad 17. Weiterhin trennen die Trennschalter 11 gemäß Fig. 2 die DC/AC-Wandler 10 nur einpolig von den Busleitungen 8 und 9, konkret von der Busleitung 9.

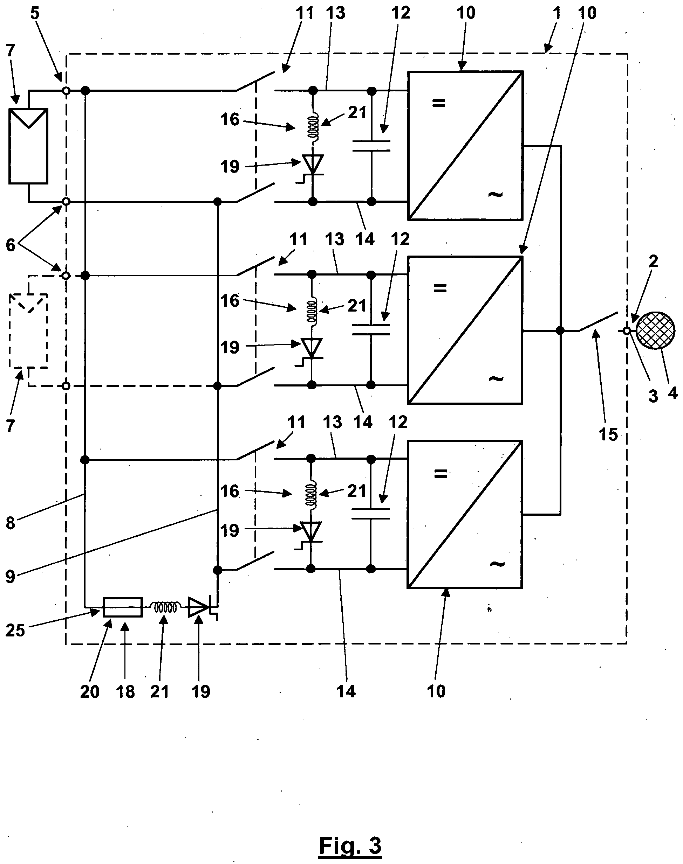

Bei der Ausführungsform der Schaltungsanordnung des Photovoltaikwechselrichters 1 gemäß **Fig. 3** ist gegenüber der Ausführungsform gemäß Fig. 1 der Kurzschlusspfad 17 mit dem Entladungswiderstand 22 weggelassen. Dafür sind hinter allen Trennschaltern 11 und vor den zugehörigen DC/AC-Wandlern 10 Kurzschlusspfade 16 zwischen die Anschlussleitungen 13 und 14 geschaltet, in denen jeweils eine Drossel 21 mit dem Kurzschlussschalter 19 in Reihe geschaltet ist. Auf diese Kurzschlusspfade 16 verteilt sich der Kurzschlussstrom und die in den Zwischenkreiskondensatoren 12 gespeicherte Energie, wenn zunächst die Kurzschlussschalter 19 in den Kurzschlusspfaden 16 geschlossen werden. Wenn dann anschließend der Kurzschlussschalter 19 in dem Kurzschlusspfad 18 geschlossen wird, wird die in Reihe geschaltete Sicherung 20 nicht sofort mit dem vollen Kurzschlussstrom belastet, sondern erst nach dem Öffnen der Trennschalter 11. Zu diesem Zeitpunkt ist das Fallen der Sicherung 20 gewünscht, sobald die Trennstrecken der Trennschalter 11 ausreichend deionisiert sind, dass sie nicht mehr leitend werden können, um den Kurzschlussstrom abzuschalten.

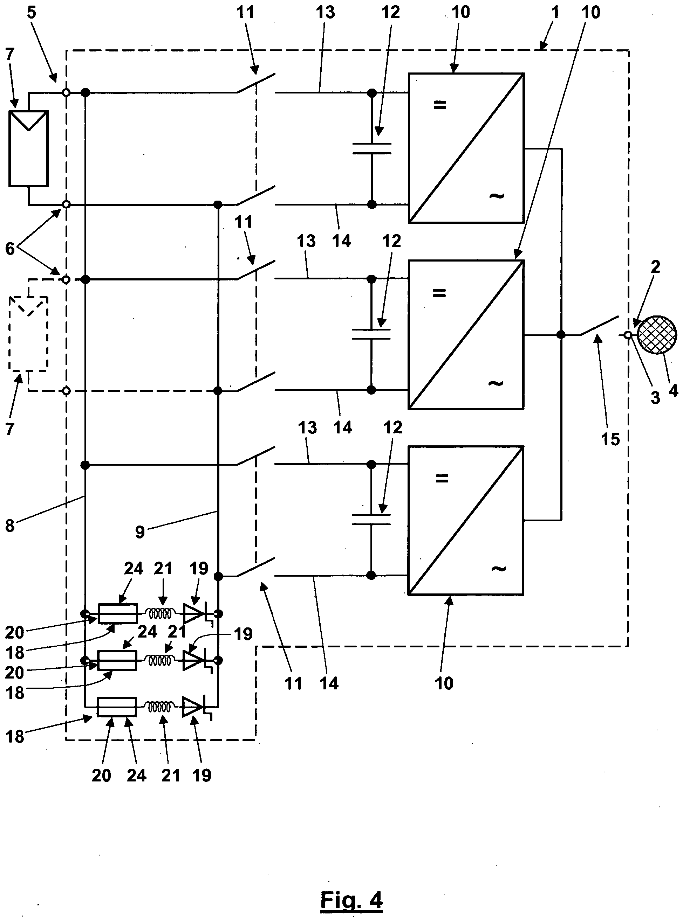

Bei der Ausführungsform der Schaltungsanordnung für den Photovoltaikwechselrichter 1 gemäß **Fig. 4** ist im Gegensatz zu dem Ausführungsbeispiel gemäß Fig. 1 weder ein Kurzschlusspfad 16 noch ein Kurzschlusspfad 17 hinter einem der Trennschalter 11 und vor dem zugehörigen DC/AC-Wandler 10 vorgesehen. Hier sind ausschließlich mehrere, im vorliegenden Beispiel konkret drei Kurzschlusspfade 18 direkt zwischen die Busleitungen 8 und 9 geschaltet. In jedem der Kurzschlusspfade 18 ist eine triggerbare Sicherung 24 als Sicherung 20 in Reihe mit der Drossel 21 und dem Kurzschlussschalter 19 geschaltet. Wenn ein schwerwiegender Fehler mit einem Kurzschluss der Busleitungen 8 und 9 durch einen der DC/AC-Wandler 10 und über den zugehörigen Trennschalter 11 auftritt, wird nach dem Öffnen des AC-Schützes 15 und dem Abschalten aller DC/AC-Wandler 10 der Kurzschlussschalter 19 eines der Kurzschlusspfade 18 geschlossen. Sobald in der Folge die Spannung zwischen den Busleitungen 8 und 9 abgefallen ist, weil die Busleitungen 8 und 9 über dem Kurzschlusspfad 18 mit geringem Widerstand kurzgeschlossen sind, werden die Trennschalter 11 geöffnet. Sobald ausreichend Zeit nach dem Öffnen der Trennschalter 11 verstrichen ist, dass die Strecken zwischen ihren Schaltkontakten nicht mehr leitend werden können, wird die Sicherung 20 des jetzt den gesamten Kurzschlussstrom führenden Kurzschlusspfads 18 getriggert, um den Kurzschlussstrom abzuschalten. Danach ist dieser Kurzschlusspfad bis zum Ersetzen seiner Sicherung 20 verbraucht. Es stehen aber noch die parallelen Kurzschlusspfade 18 für ein erneutes sicheres Abschalten eines Kurzschlussstroms zur Verfügung.

### BEZUGSZEICHENLISTE

- 1: Photovoltaikwechselrichter
- 2: Ausgang
- 3: Ausgangsanschluss
- 4: Wechselstromnetz
- 5: Eingang
- 6: Eingangsanschluss
- 7: Photovoltaikgenerator
- 8: Busleitung
- 9: Busleitung
- 10: DC/AC-Wandler
- 11: Trennschalter
- 12: Zwischenkreiskondensator
- 13: Anschlussleitung
- 14: Anschlussleitung
- 15: AC-Schütz
- 16: Kurzschlusspfad
- 17: Kurzschlusspfad
- 18: Kurzschlusspfad
- 19: Kurzschlussschalter
- 20: Sicherung
- 21: Drossel
- 22: Entladewiderstand
- 23: GTO
- 24: Triggerbare Sicherung
- 25: Schmelzsicherung

## Patentansprüche

1. Schaltungsanordnung für einen Photovoltaikwechselrichter (1) mit:
- zwei Busleitungen (8, 9),
- Eingangsanschlüssen (6) zum Anschließen mindestens eines Photovoltaikgenerators (7) an die Busleitungen (8, 9),
- mindestens einem an die Busleitungen (8, 9) angeschlossenen DC/AC-Wandler (10),
- jeweils einem Trennschalter (11) zwischen jedem DC/AC-Wandler (10) und den Busleitungen (8, 9) und
- mindestens einem Kurzschlusspfad (18) zum Kurzschließen einer zwischen den Busleitungen (8, 9) anliegenden Spannung, in dem ein Kurzschlussschalter (19) angeordnet ist, wobei der mindestens eine Kurzschlusspfad (18) zwischen den Busleitungen (8, 9) vor allen Trennschaltern (11) verläuft,
**dadurch gekennzeichnet,**
- **dass** der Kurzschlussschalter (19) in dem mindestens einen Kurzschlusspfad (18) zwischen den Busleitungen (8, 9) mit einer Sicherung (20) in Reihe geschaltet ist; und
- **dass** mindestens ein weiterer Kurzschlusspfad (16 bis 18) zum Kurzschließen der zwischen den Busleitungen (8, 9) anliegenden Spannung vorhanden ist, in dem ebenfalls ein Kurzschlussschalter (19) angeordnet ist, wobei der mindestens eine weitere Kurzschlusspfad (16, 17) hinter dem Trennschalter (11) und zwischen den Anschlussleitungen (13, 14) des mindestens einen DC/AC-Wandlers (10) verläuft.

2. Schaltungsanordnung nach Anspruch 1, **dadurch gekennzeichnet, dass** die Kurzschlussschalter (19) in allen Kurzschlusspfaden (16 bis 18) Thyristoren sind.

3. Schaltungsanordnung nach Anspruch 1 oder 2, **dadurch gekennzeichnet, dass** der Kurzschlussschalter (19) in dem mindestens einen Kurzschlusspfad (18) zwischen den Busleitungen (8, 9) weiterhin mit einem strombegrenzenden Bauteil in Reihe geschaltet ist.

4. Schaltungsanordnung nach einem der vorhergehenden Ansprüche, **dadurch gekennzeichnet, dass** mindestens zwei DC/AC-Wandler (10) an die Busleitungen (8, 9) angeschlossen sind und dass hinter mindestens zwei der Trennschalter (11) der mindestens zwei DC/AC-Wandler (10) jeweils einer der weiteren Kurzschlusspfade (16, 17) zwischen den Anschlussleitungen (13, 14) des zugehörigen DC/AC-Wandlers (10) verläuft.

5. Schaltungsanordnung nach einem der vorhergehenden Ansprüche, **dadurch gekennzeichnet, dass** hinter jedem Trennschalter (11) einer der weiteren Kurzschlusspfade (16, 17) zwischen den Anschlussleitungen (13, 14) des zugehörigen DC/AC-Wandlers (10) verläuft.

6. Schaltungsanordnung nach einem der vorhergehenden Ansprüche, **dadurch gekennzeichnet, dass** in jedem weiteren Kurzschlusspfad (16, 17) ein strombegrenzendes Bauteil mit dem jeweiligen Kurzschlussschalter (19) in Reihe geschaltet ist.

7. Schaltungsanordnung nach Anspruch 6, **dadurch gekennzeichnet, dass** das strombegrenzende Bauteil in mindestens einem (17) der weiteren Kurzschlusspfade ein Entladewiderstand (22) für eingangsseitige Zwischenkreiskondensatoren (12) der DC/AC-Wandler (10) ist.

8. Schaltungsanordnung nach Anspruch 6 oder 7, **dadurch gekennzeichnet, dass** das strombegrenzende Bauteil in mindestens einem (16) der weiteren Kurzschlusspfade eine Drossel (21) ist.

9. Schaltungsanordnung nach einem der vorhergehenden Ansprüche, **dadurch gekennzeichnet, dass** ein zweiter weiterer Kurzschlusspfad (16 bis 18) parallel zu dem mindestens einen Kurzschlusspfad (18) zwischen den Busleitungen (8, 9) vor allen Trennschaltern (11) verläuft, wobei der Kurzschlussschalter (19) auch in dem zweiten weiteren Kurzschlusspfad (18) mit einer Sicherung (20) in Reihe geschaltet ist.

10. Schaltungsanordnung nach einem der vorhergehenden Ansprüche, **dadurch gekennzeichnet, dass** jeder Trennschalter (11) den zugehörigen DC/AC-Wandler (10) allpolig von den Busleitungen (8, 9) trennt.

11. Schaltungsanordnung nach einem der vorhergehenden Ansprüche, **dadurch gekennzeichnet, dass** alle DC/AC-Wandler (10) ausgangsseitig über ein gemeinsames AC-Schütz (15) oder jeder DC/AC-Wandler (10) ausgangsseitig über ein eigenes AC-Schütz mit einem Ausgangsanschluss (3) für ein Wechselstromnetz (4) verbindbar sind/ist.

12. Verwendung einer Schaltungsanordnung für einen Photovoltaikwechselrichter (1) nach einem der Ansprüche 1 bis 11, **dadurch gekennzeichnet, dass** alle Trennschalter (11) bei leitenden Kurschlussschaltern (19) geöffnet werden oder dass der Trennschalter (11) des mindestens einen DC/AC-Wandlers (10), wenn ein DC-Strom von den Busleitungen (8, 9) zu dem mindestens einen DC/AC-Wandler (10) fließt, der ein Grenzausschaltvermögen des Trennschalters (11) übersteigt, bei leitenden Kurzschlussschaltern (19) geöffnet wird.

13. Verwendung nach Anspruch 12, **dadurch gekennzeichnet, dass** alle Kurzschlussschalter (19) in allen Kurzschlusspfaden zwischen den Busleitungen (8, 9) vor allen Trennschaltern (11) erst nach allen Kurzschlussschaltern (19) in allen Kurzschlusspfaden hinter allen Trennschaltern (11) und zwischen den Anschlussleitungen (13, 14) des zugehörigen DC/AC-Wandlers (10) geschlossen werden.

14. Verwendung nach Anspruch 12 oder 13 einer Schaltungsanordnung nach Anspruch 7 oder einem der darauf rückbezogenen Ansprüche, **dadurch gekennzeichnet, dass** jeder in einem der weiteren Kurzschlusspfade (17) in Reihe mit einem Entladewiderstand (22) geschaltete Kurzschlussschalter (19) geschlossen wird, bevor alle anderen Kurzschlussschalter (19) geschlossen werden.

15. Verwendung nach einem der Ansprüche 12 bis 14 einer Schaltungsanordnung nach Anspruch 11, **dadurch gekennzeichnet, dass** das oder die AC-Schütze (15) abgeschaltet werden, bevor die Kurzschlussschalter (19) geschlossen werden.

## Claims

1. Circuit arrangement for a photovoltaic inverter (1) with:
- two bus lines (8, 9),
- input terminals (6) for connecting at least one photovoltaic generator (7) to the bus lines (8, 9),
- at least one DC/AC converter (10) connected to the bus lines (8, 9),
- in each case an isolation switch (11) between each DC/AC converter (10) and the bus lines (8, 9), and
- at least one short-circuit path (18) for short-circuiting a voltage applied between the bus lines (8, 9), in which a short-circuit switch (19) is arranged, wherein the at least one short-circuit path (18) between the bus lines (8, 9) is arranged upstream of all isolation switches (11),
**characterized in that**
- the short-circuit switch (19) in the at least one short-circuit path (18) between the bus lines (8, 9) is connected in series with a fuse (20); and
- at least one further short-circuit path (16 to 18) for short-circuiting the voltage applied between the bus lines (8, 9) exist, in which also a short-circuit switch (19) is arranged, wherein the at least one further short-circuit path (16, 17) is arranged downstream of the isolation switch (11) and between the connecting lines (13, 14) of the at least one DC/AC converter (10).

2. Circuit arrangement according to claim 1, **characterized in that** the short-circuit switches (19) in all short-circuit paths (16 to 18) are thyristors.

3. Circuit arrangement according to claim 1 or 2, **characterized in that** the short-circuit switch (19) in the at least one short-circuit path (18) between the bus lines (8, 9) is further connected in series with a current-limiting component.

4. Circuit arrangement according to any one of the preceding claims, **characterized in that** at least two DC/AC converters (10) are connected to the bus lines (8, 9) and that downstream of at least two of the isolation switches (11) of the at least two DC/AC converters (10) in each case one of the further short-circuit paths (16, 17) is arranged between the connecting lines (13, 14) of the associated DC/AC converter (10).

5. Circuit arrangement according to any one of the preceding claims, **characterized in that** downstream of each isolation switch (11) one of the further short-circuit paths (16, 17) is arranged between the connecting lines (13, 14) of the associated DC/AC converter (10).

6. Circuit arrangement according to any one of the preceding claims, **characterized in that** in each further short-circuit path (16, 17) a current-limiting component is connected in series with the respective short circuit switch (19).

7. Circuit arrangement according to claim 6, **characterized in that** the current-limiting component in at least one (17) of the further short-circuit paths is a discharge resistor (22) for input-side intermediate circuit capacitors (12) of the DC/AC converters (10).

8. Circuit arrangement according to claim 6 or 7, **characterized in that** the current-limiting component in at least one (16) of the further short-circuit paths is an inductor (21).

9. Circuit arrangement according to any one of the preceding claims, **characterized in that** a second further short-circuit path (16 to 18) is arranged in parallel to the at least one short-circuit path (18) between the bus lines (8, 9) upstream of all isolation switches (11), wherein the short-circuit switch (19) is connected in series with a fuse (20) also in the second further short-circuit path (18).

10. Circuit arrangement according to any one of the preceding claims, **characterized in that** each isolation switch (11) effects all-pole disconnection of the associated DC/AC converter (10) from the bus lines (8, 9).

11. Circuit arrangement according to any one of the preceding claims, **characterized in that** all DC/AC converters (10) are connectable on the output side via a common AC contactor (15) or each DC/AC converter (10) is connectable on the output side via an own AC contactor to an output terminal (3) for an AC network (4).

12. Use of a circuit arrangement for a photovoltaic inverter (1) according to any one of claims 1 to 11, **characterized in that** all the isolation switches (11) are opened in conductive state of the short-circuit switches (19) or that the isolation switch (11) of the at least one DC/AC converter (10), if a DC current flows from the bus lines (8, 9) to the at least one DC/AC converter (10) that exceeds a limiting break capacity of the disconnector (11), is opened in conductive state of the short-circuit switches (19).

13. Use according to claim 12, **characterized in that** all the short-circuit switches (19) in all the short-circuit paths between the bus lines (8, 9) upstream of all isolation switches (11) are closed only after all short-circuit switches (19) in all short-circuit paths downstream of all isolation switches (11) and between the connecting lines (13, 14) of the associated DC/AC converter (10).

14. Use according to claim 12 or 13 of a circuit arrangement according to claim 7 or any one of the claims referring back thereto, **characterized in that** each short-circuit switch (19) connected in series with a discharge resistor (22) in one of the further short-circuit paths (17) is closed before all other short-circuit switches (19) are closed.

15. Use according to any one of claims 12 to 14 of a circuit arrangement according to claim 11, **characterized in that** the AC contactor(s) (15) is/are turned off before the short-circuit switches (19) are closed.

## Revendications

1. Arrangement de circuit pour un onduleur photovoltaïque (1), comprenant :
- deux lignes de bus (8, 9),
- des bornes d'entrée (6) destinées à raccorder au moins un générateur photovoltaïque (7) aux lignes de bus (8, 9),
- au moins un convertisseur CC/CA (10) raccordé aux lignes de bus (8, 9),
- respectivement un sectionneur (11) entre chaque convertisseur CC/CA (10) et les lignes de bus (8, 9) et
- au moins un trajet de court-circuit (18) destiné à court-circuiter une tension appliquée entre les lignes de bus (8, 9), dans lequel est disposé un commutateur de court-circuit (19), l'au moins un trajet de court-circuit (18) s'étendant entre les lignes de bus (8, 9) avant tous les sectionneurs (11),
**caractérisé en ce**
- **que** le commutateur de court-circuit (19) dans l'au moins un trajet de court-circuit (18) entre les lignes de bus (8, 9) est branché en série avec un fusible (20) ; et
- **qu'**il existe au moins un trajet de court-circuit (16 à 18) supplémentaire destiné à court-circuiter la tension appliquée entre les lignes de bus (8, 9), dans lequel est également disposé un commutateur de court-circuit (19), l'au moins un trajet de court-circuit (16 à 18) supplémentaire s'étendant après le sectionneur (11) et entre les lignes de raccordement (13, 14) de l'au moins un convertisseur CC/CA (10).

2. Arrangement de circuit selon la revendication 1, **caractérisé en ce que** les commutateurs de court-circuit (19) dans tous les trajets de court-circuit (16 à 18) sont des thyristors.

3. Arrangement de circuit selon la revendication 1 ou 2, **caractérisé en ce que** le commutateur de court-circuit (19) dans l'au moins un trajet de court-circuit (18) entre les lignes de bus (8, 9) est en outre branché en série avec un composant limiteur de courant.

4. Arrangement de circuit selon l'une des revendications précédentes, **caractérisé en ce qu'**au moins deux convertisseurs CC/CA (10) sont raccordés aux lignes de bus (8, 9), et **en ce qu'**après au moins deux des sectionneurs (11) des au moins deux convertisseurs CC/CA (10), l'un des trajets de court-circuit (16, 17) supplémentaires s'étend respectivement entre les lignes de raccordement (13, 14) du convertisseur CC/CA (10) associé.

5. Arrangement de circuit selon l'une des revendications précédentes, **caractérisé en ce qu'**après chaque sectionneur (11), l'un des trajets de court-circuit (16, 17) supplémentaires s'étend entre les lignes de raccordement (13, 14) du convertisseur CC/CA (10) associé.

6. Arrangement de circuit selon l'une des revendications précédentes, **caractérisé en ce qu'**un composant limiteur de courant est branché en série avec le commutateur de court-circuit (19) dans chaque trajet de court-circuit (16, 17) supplémentaire.

7. Arrangement de circuit selon la revendication 6, **caractérisé en ce que** le composant limiteur de courant dans au moins l'un (17) des trajets de court-circuit supplémentaires est une résistance de décharge (22) pour des condensateurs de circuit intermédiaire (12) en entrée du convertisseur CC/CA (10).

8. Arrangement de circuit selon la revendication 6 ou 7, **caractérisé en ce que** le composant limiteur de courant dans au moins l'un (16) des trajets de court-circuit supplémentaires est une inductance (21).

9. Arrangement de circuit selon l'une des revendications précédentes, **caractérisé en ce qu'**un deuxième trajet de court-circuit (16 à 18) supplémentaire s'étend en parallèle de l'au moins un trajet de court-circuit (18) entre les lignes de bus (8, 9) avant tous les sectionneurs (11), le commutateur de court-circuit (19) étant branché en série avec un fusible (20) également dans le deuxième trajet de court-circuit (18) supplémentaire.

10. Arrangement de circuit selon l'une des revendications précédentes, **caractérisé en ce que** chaque sectionneur (11) déconnecte tous les pôles du convertisseur CC/CA (10) associé des lignes de bus (8, 9).

11. Arrangement de circuit selon l'une des revendications précédentes, **caractérisé en ce que** tous les convertisseurs CC/CA (10) peuvent être reliés du côté de la sortie par le biais d'un contacteur CA (15) commun, ou chaque convertisseur CC/CA (10) peut être relié du côté de la sortie par le biais d'un contacteur CA propre, avec une borne de sortie (3) pour un réseau de courant alternatif (4).

12. Utilisation d'un arrangement de circuit pour un onduleur photovoltaïque (1) selon l'une des revendications 1 à 11, **caractérisée en ce que** tous les sectionneurs (11) sont ouverts lorsque les commutateurs de court-circuit (19) sont passants, ou **en ce que** le sectionneur (11) de l'au moins un convertisseur CC/CA (10) est ouvert lorsque les commutateurs de court-circuit (19) sont passants si un courant continu qui dépasse une capacité de déconnexion limite du sectionneur (11) circule des lignes de bus (8, 9) vers l'au moins un convertisseur CC/CA (10).

13. Utilisation selon la revendication 12, **caractérisée en ce que** tous les commutateurs de court-circuit (19) dans tous les trajets de court-circuit entre les lignes de bus (8, 9) avant tous les sectionneurs (11) ne sont fermés qu'après que tous les commutateurs de court-circuit (19) dans tous les trajets de court-circuit après tous les sectionneurs (11) et entre les lignes de raccordement (13, 14) du convertisseur CC/CA (10) associé soient fermés.

14. Utilisation selon la revendication 12 ou 13 d'un arrangement de circuit selon la revendication 7 ou l'une des revendications s'y rapportant, **caractérisée en ce que** chaque commutateur de court-circuit (19) branché en série avec une résistance de décharge (22) dans l'un des trajets de court-circuit (17) supplémentaires est fermé avant que tous les autres commutateurs de court-circuit (19) soient fermés.

15. Utilisation selon la revendication 12 ou 14 d'un arrangement de circuit selon la revendication 11, **caractérisée en ce que** le ou les contacteurs CA (15) sont déconnectés avant que les commutateurs de court-circuit (19) soient fermés.
